# EUROPÄISCHE PATENTSCHRIFT

(11) **EP 0 259 716 B1**
(45) Veröffentlichungstag und Bekanntmachung des Hinweises auf die Patenterteilung: **25.05.1994**
(21) Anmeldenummer: 87112511.8
(22) Anmeldetag: 28.08.1987
(51) Int. Cl.: B23D 45/20, B23D 47/00

(54) **Verfahren und Vorrichtung zur Aufteilung metallkaschierter Laminatbahnen in einzelne Platten**
Method and apparatus for dividing metal-coated laminated strips into plates
Procédé et dispositif pour débiter des bandes laminées en plaques

(30) Priorität: 05.09.1986 DE 3630269
(43) Veröffentlichungstag der Anmeldung: 16.03.1988
(73) Patentinhaber: Held, Kurt, D-78647 Trossingen (DE)
(72) Erfinder: Held, Kurt, D-78647 Trossingen (DE)

(56) Entgegenhaltungen:
- EP-A- 0 120 192
- DE-A- 2 118 527
- FR-A- 2 501 551
- US-A- 2 538 972
- US-A- 2 941 451
- US-A- 3 421 556
- US-A- 3 623 518
- US-A- 3 757 618
- US-A- 4 058 150
- US-A- 4 221 974
- US-A- 4 414 874
- HOLZ ALS ROH- UND WERKSTOFF, Band 44, Nr. 3, März 1986, Seiten 93-96, Berlin,DE; M. ROTTMANN: "Plattenaufteilanlagen unmittelbar hinter kontinuierlicharbeitenden Plattenpressen"

## Beschreibung

Die Erfindung betrifft ein Verfahren zum Aufteilen einer kontinuierlich vorlaufenden, endlosen metallkaschierten Laminatbahn in einzelne Platten nach dem Oberbegriff des Patentanspruchs 1 und eine Vorrichtung zur Durchführung dieses Verfahrens.

Metallkaschierte Laminate bestehen aus einem Schichtstoffkern, wobei auf mindestens eine Oberfläche diese Schichtstoffkerns eine Metallfolie aufgelegt und mit dieser fest verbunden ist. Der Schichtstoffkern wiederum setzt sich in der Regel aus einzelnen Lagen von mit duroplastischem Harz getränkten Trägermaterialien zusammen. Ein solches metallkaschiertes Laminat ist beispielsweise das kupferkaschierte Elektrolaminat, das als Ausgangsmaterial zur Leiterplattenherstellung dient. Es besteht aus einzelnen Lagen von mit Epoxyharz imprägniertem Glasfasergewebe, die unter Einwirkung von Hitze und Druck mit galvanisch abgeschiedenen Kupferfolien von hoher Reinheit verpresst sind.

Zur Herstellung solcher metallkaschierter Laminate werden zunehmend kontinuierliche Verfahren eingesetzt, da diese gegenüber den diskontinuierlichen Verfahren eine gesteigerte Quantität und Qualität aufweisen. Ein solches kontinuierliches Verfahren, das mittels einer Doppelbandpresse arbeitet, wird in der DE-OS 33 07 057 angegeben. Da bei den kontinuierlichen Verfahren das metallkaschierte Laminat als endlose Bahn anfällt, ist es jedoch nötig, diese Bahn anschliessend in einzelne Platten aufzuteilen.

Es ist aus der obengenannten Offenlegungsschrift bekannt, hinter der Doppelbandpresse eine Schlagschere anzuordnen. Mit einer solchen Schere erhält man Platten, die die Breite der Laminatbahn und die Länge gewisser vorgegebener Standardfixmasse besitzen. Mit dieser Methode erhält man jedoch keine saubere Schnittkante. An der mit der Schere hergestellten Schnittkante hebt sich im Randbereich die Metallfolie vom Schichtstoffkern ab. Beim Anfassen dieser Kante dringen Glasfasern in die Haut ein und der zur Beschleunigung der Abbindereaktion des Harzes verwendete Härter, der an den Glasfasern haftet, führt zu Juckreizen, Allergien u. dgl. Es ist daher nötig, die Grate an diesen Schnittkanten zu entfernen, indem die Schnittkanten mit einem Fräser nachgearbeitet werden. Diese Nachbearbeitung verursacht zusätzliche Kosten.

Es ist weiter bekannt, die üblichen in den Holzbearbeitungsanlagen verwendeten Kreissägen zum Schneiden diskontinuierlich hergestellter metallkaschierter Laminate zu benützen. Dabei entsteht jedoch ebenfalls eine unsaubere Kante, die wieder nachbearbeitet werden muss. Um diesem abzuhelfen, werden mehrere gleichgrosse Platten der metallkaschierten Laminate übereinandergeschichtet, zusammengespannt und dann in kleinere Platten zersägt, wobei die Schnittkante dann etwas besser wird. Allerdings ist ein solches Vorgehen wieder mit kostenintensiver manueller Arbeit verbunden und kann nicht automatisiert werden. Zudem ist ein solches Verfahren nur bei diskontinuierlicher Herstellung der metallkaschierten Laminate sinnvoll anwendbar, da die übereinanderzuspannenden Laminate bereits als Platten mit gewissen Fixmassen vorliegen müssen. Es ist somit unmittelbar ersichtlich, dass diese Vorgehensweise bei der kontinuierlichen Herstellung metallkaschierter Laminate nicht einsetzbar ist.

Aus dem Artikel "Plattenaufteilanlagen unmittelbar hinter kontinuierlich arbeitenden Plattenpressen" aus der Druckschrift "Holz als Roh- und Werkstoff, 44 (1986) März, Nr. 3, Berlin, Deutschland, Seiten 93 bis 96, ist eine Aufteilsägemaschine bekannt, welche im Anschluß an eine kontinuierlich arbeitende Plattenpresse angeordnet ist und für den Zuschnitt der endlos gefertigten Platten eingesetzt wird. Es handelt sich um eine Diagonalsäge-Anlage, welche aus schräg zur Plattenförderrichtung aufgestellten Portalen mit Fahrträgern und Sägewagen besteht. Die Trennsägen sind an den Sägewagen auf Kugelführungen vertikalpneumatisch heb- und senkbar angebracht. Der Arbeitshub erfolgt in abgesenkter, der Leerhub in angehobener Position. Der Aufstellungswinkel errechnet sich aus der maximal erforderlichen Plattenbandgeschwindigkeit und der maximal zulässigen Sägewagengeschwindigkeit. Die Steuerung der Diagonalsäge übernimmt, in Verbindung mit einer frei programmierbaren Steuerung, eine CNC-Steuerung. Es können unterschiedliche Schnittlängenprogramme gespeichert und nacheinander abgearbeitet werden.

Nachteilig bei diesen bekannten Verfahren zur Aufteilung metallkaschierter Laminate ist, daß die Platten im allgemeinen noch nachbearbeitungsbedürftige Schnittkanten liefern. Somit fallen nach der Aufteilung noch zusätzliche Arbeitsgänge an den Platten an und bereits beim Aufteilen der Laminate müssen Materialzugaben für diese Arbeitsgänge eingeplant werden.

Der Erfindung liegt die Aufgabe zugrunde, das Verfahren zur Aufteilung einer kontinuierlich hergestellten metallkaschierten Laminatbahn so weiterzuentwickeln, daß Platten produziert werden, deren Schnittkanten nicht mehr nachbearbeitet werden müssen.

Das zur Lösung dieser Aufgabe dienende Verfahren wird durch die im Kennzeichen des Patentanspruchs 1 beschriebene technische Lehre vermittelt und eine zur Durchführung diese Verfahrens dienende Vorrichtung im Kennzeichen des Patentanspruchs 9 angegeben.

Die mit der Erfindung erzielbaren Vorteile bestehen insbesondere darin, dass die kontinuierlich erzeugte metallkaschierte Laminatbahn in Platten beliebiger Grösse aufgeteilt werden kann. Dadurch entfällt das Verschnittmaterial weitgehends. Durch eine rechnergestützte Optimierung der Plattenaufteilung, entsprechend dem Unteranspruch 3, lässt sich der Verschnitt noch weiter minimieren. Durch die Seitenabstützung des Sägeblattes entstehen saubere Schnittkanten an den Plattenrändern, so dass eine Nachbearbeitung und diesbezügliche Kosten entfallen. Damit müssen beim Schneiden auch keine Zugaben für eine Nachbearbeitung einkalkuliert werden, so dass daraus wiederum eine bessere Ausnutzung der metallkaschierten Laminatbahn resultiert. Selbst wenn die metallkaschierte Laminatbahn nur in rechtwinklige Platten mit derselben Breite wie die Laminatbahn und variabler Länge aufgeteilt werden soll, lässt sich das erfindungsgemässe Verfahren ebenfalls anwenden. Die Säge wird dann in Vorlaufrichtung der Laminatbahn mit derselben Geschwindigkeit wie die Laminatbahn bewegt. Vorteilhafterweise werden dazu die Laufwagen für die Bahnebewegung des Sägeblattes in Vorlaufrichtung der Laminatbahn starr mit der Laminatbahn während des Sägevorgangs gekoppelt. Auch hier erhält man wiederum eine saubere, nicht nachbearbeitungsbedürftiger Schnittkante unter minimal verbrauchtem Material an der Schnittkante.

Das erfindungsgemässe Verfahren und die zugehörige Vorrichtung lassen sich besonders vorteilhaft in Verbindung mit einer Anlage zur Herstellung von kupferkaschierten Elektrolaminaten, die mit einer Doppelbandpresse ausgestattet ist, anwenden.

Das erfindungsgemässe Verfahren wird anhand eines bevorzugten Ausführungsbeispieles für die Vorrichtung, die in den Zeichnungen dargestellt ist, im folgenden näher beschrieben. Es zeigen
- Fig. 1: eine Gesamtansicht einer Vorrichtung zur kontinuierlichen Herstellung kupferkaschierter Elektrolaminate einschliesslich der Aufteilung der Elektrolaminatbahn in Platten,
- Fig. 2: eine NC-Säge für die Aufteilung der Elektrolaminatbahn,
- Fig. 3: den Sägekopf am Schlitten in der NC-Säge entlange eines vertikalen Schnittes zwischen den beiden Führungsachsen in zur Vorlaufrichtung der Laminatbahn senkrechter Richtung,
- Fig. 4: einen Schnitt durch den Sägekopf entlang der Linie A-B aus Fig. 3,
- Fig. 5: einen Schnitt E-F aus der Fig. 3 durch die Seitenabstützung für das Sägeblatt,
- Fig. 6: einen vergrösserten Ausschnitt aus Fig. 5, der die Schneidenplättchen zeigt,
- Fig. 7: einen Schnitt entlang der Linie C-D aus Fig. 6 mit den auftretenden Kräften und
- Fig. 8: eine perspektivische Draufsicht auf das Schneidenplättchen.

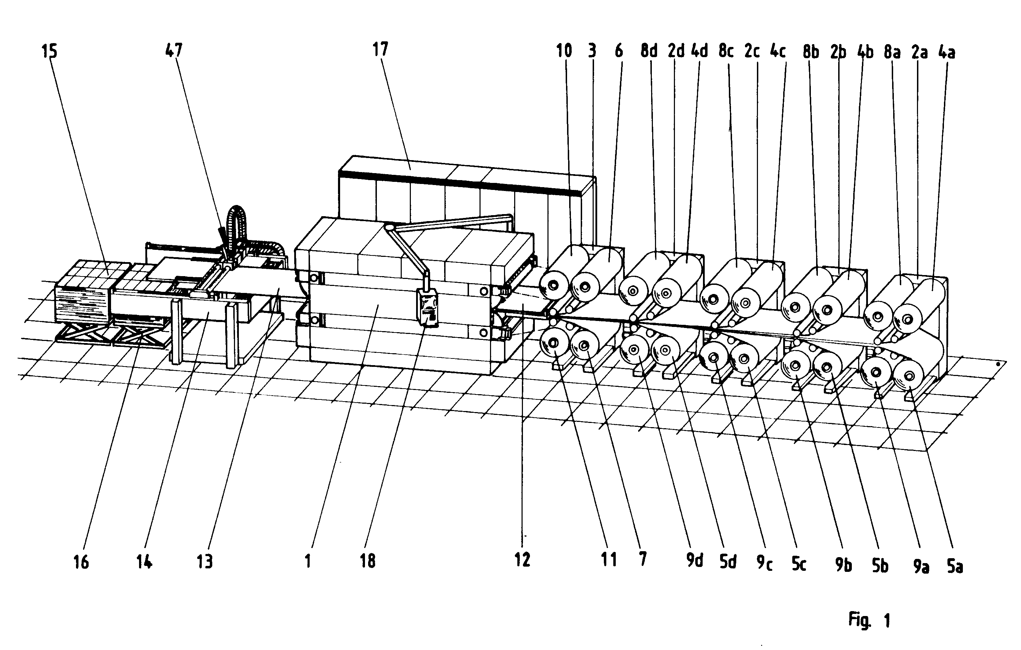

Die Vorrichtung zur kontinuierlichen Herstellung von metallkaschierten Laminaten - im vorliegenden Ausführungsbeispiel handelt es sich um kupferkaschierte Elektrolaminate - besteht, wie in Fig. 1 gezeigt, aus einer Doppelbandpresse 1 mit einigen davor und dahinter angeordneten Aggregaten. Vor der Doppelbandpresse 1 sind Abwickeleinheiten 2a bis 2d und 3 mit darin angebrachten Vorratsrollen 4a-d, 5a-d, 6 und 7 angeordnet. Die Vorratsrollen 4a-d und 5a-d beinhalten das mit Epoxyharz imprägnierte Glasfasergewebe, das kontinuierlich von diesen Rollen abgezogen und entsprechend dem gewünschten Aufbau des Schichtstoffkerns in die Doppelbandpresse 1 eingeführt wird. Diese Glasfasergewebebahnen bilden den Schichtstoffkern des Elektrolaminats. Auf die obere und untere Oberfläche des Schichtstoffkerns wird jeweils eine elektrolytisch abgeschiedene Kupferfolie gelegt, die von der Vorratsrolle 6 bzw. 7 in der Abwickeleinheit 3 abgezogen wird.

Bei der hier gezeigten Anlage besteht der Schichtstoffkern also aus insgesamt acht harzimprägnierten Glasfaserbahnen. Je nach erforderlicher Dicke des Elektrolaminats bzw. dessen gewünschter Stabilität kann der Schichtstoffkern auch aus mehr oder weniger Glasfaserbahnen zusammengesetzt sein. Falls gewünscht können daher weitere Abwickeleinheiten vor der Doppelbandpresse 1 angeordnet sein oder die nicht benötigten Abwikkeleinheiten ohne Vorratsrollen ausgerüstet sein. Durch Weglassen von einer der Vorratsrollen 6 oder 7 kann auch ein nur einseitig kupferkaschiertes Elektrolaminat erzeugt werden. Wie in Fig. 1 weiter zu sehen, ist in jeder Abwickeleinheit 2a-d und 3 für jede Vorratsrolle 4a-d, 5a-d, 6 und 7 eine Ersatzrolle 8a-d, 9a-d, 10 und 11 vorgesehen, von der die Bahn abgezogen wird, sobald eine Vorratsrolle leer ist. Damit kann die Herstellung des Elektrolaminats auch in einem solchen Fall ohne Produktionsunterbrechung weiterlaufen.

Die hinter der Abwickeleinheit 3 entsprechend dem Aufbau des Elektrolaminats geschichtet aufeinanderliegenden Bahnen 12 werden dann in die Doppelbandpresse 1 eingeführt und dort unter dem Einfluss von Wärme und Flächendruck kontinuierlich zum Elektrolaminat verpresst. Die Doppelbandpresse 1 kann in eine Heiz- und Kühlzone eingeteilt sein, so dass das Elektrolaminat bereits in der Doppelbandpresse 1 unter der Wirkung des Drucks abgekühlt wird. Das Elektrolaminat verlässt anschliessend als kompakte Elektrolaminatbahn 13 die Doppelbandpresse 1 mit gleichförmiger Geschwindigkeit und wird in den hinter der Doppelbandpresse 1 folgenden Anlagenteilen weiter bearbeitet. Falls erforderlich kann die Elektrolaminatbahn 13 dann eine weitere, in der Zeichnung nicht gezeigte Kühleinrichtung zur weiteren Abkühlung durchlaufen. Anschliessend wird die Elektrolaminatbahn 13 in der Querschneidestation 14 in einzelne Platten 15 unterteilt, die zum Abtransport auf Paletten in einer Stapeleinrichtung 16 gestapelt werden.

Der gesamte Verfahrensablauf in der in Fig. 1 gezeigten Anlage, also die Abwicklung der einzelnen Bahnen, die Vorgabe und Konstanthaltung der Prozessparameter in der Doppelbandpresse und die Aufteilung der Elektrolaminatbahn 13 in einzelne Platten, wird von einem Rechner, der im Schaltschrank 17 angeordnet ist, gesteuert. Zur Eingabe der Parameter durch den Benutzer dient das Datenterminal 18. Selbstverständlich kann der Rechner im Schaltschrank 17 auch an einen externen Hostrechner, der sich beispielsweise in der Zentral-EDV befindet, angeschlossen sein, um eine Steuerung der Produktion und Rückmeldung der Produktionsdaten zur weiteren Auswertung direkt von der Zentrale aus zu ermöglichen.

Die Querschneidestation 14, die die Elektrolaminatbahn 13 in einzelne Platten 15 aufteilt, ist eine bahngesteuerte NC-Säge mit einem in zwei zueinander senkrecht stehenden Achsen verfahrbarem Sägekopf 47. Diese Achsen, an denen der Sägekopf 47 verfahrbar ist, sind so angeordnet, dass sie in x- und y-Richtung verlaufen. Mit x-Richtung wird dabei die Vorlaufrichtung der Elektrolaminatbahn 13 und mit y-Richtung die dazu senkrechte, in der Ebene der Elektrolaminatbahn 13 liegende Richtung bezeichnet. Falls erforderlich kann der Sägekopf 47 zusätzlich um eine vertikale Achse, die senkrecht zur x- und y-Richtung steht, drehbar ausgebildet sein. Der Sägekopf 47 der Querschneidestation 14 wird ebenfalls von dem Rechner im Schaltschrank 17 gesteuert. Der Betreiber der Anlage gibt über das Datenterminal 18 oder einen Hostrechner in der Zentral-EDV, der mit dem Rechner im Schaltschrank 17 gekoppelt ist, die Grössen der gewünschten Platten 15 und deren Form, falls diese von einem Rechteck abweicht, für eine Tagesproduktion oder einen Produktionsabschnitt ein, da entsprechend dem erfindungsgemässen Verfahren eine Aufteilung der endlosen Elektrolaminatbahn 13 in beliebige Plattengrössen und -formen möglich ist. Der Rechner berechnet nun die günstigste Aufteilung aufgrund dieser vorgegebenen Masse so, dass ein geringstmöglicher Verschnitt resultiert.

Aufgrund dieser Berechnung legt der Rechner die Reihenfolge für die einzelnen Platten fest und ermittelt die Steuersignale für die NC-Säge entsprechend der festgelegten Reihenfolge unter Berücksichtigung der Vorschubgeschwindigkeit der Elektrolaminatbahn 13, die von den Prozessparametern in der Doppelbandpresse 1 bestimmt wird, der jeweiligen Plattenform und -grösse. Diese Steuersignale werden dann an den Sägekopf 47 in der Querschneidestation 14 zur Ansteuerung der Motoren übergeben, so dass die gewünschten Platten aus der kontinuierlich vorlaufenden Elektrolaminatbahn 13 ausgesägt und in der Stapeleinrichtung 16 zum Abtransport abgelegt werden. Diese Platten sind bereits versandfertig, da deren Kanten aufgrund der erfindungsgemässen seitlichen Abstützung der Schnittkante auf der Elektrolaminatbahn 13 am Sägeblatt keinerlei weiteren Nachbearbeitung bedürfen. Vorteilhafterweise kann die Reihenfolge der Aufteilung in einzelne Platten vom Rechner über einen Drucker, der sich beispielsweise in der Zentral-EDV befindet, zur Dokumentation ausgedruckt werden. Eine gleichzeitige Ausgabe des Lieferscheins für die einzelnen Platten 15 ist dann ebenfalls möglich.

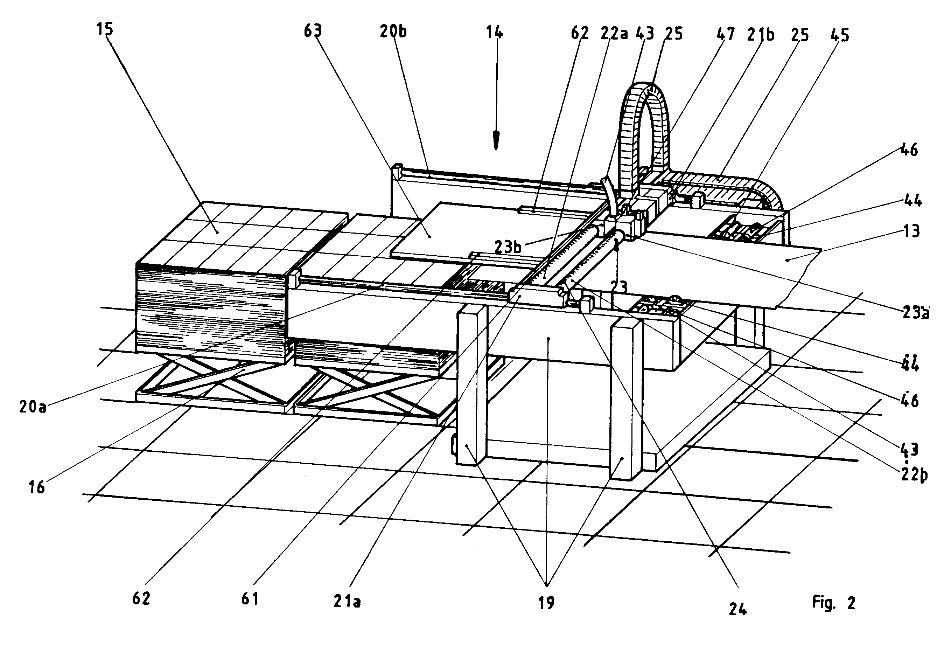

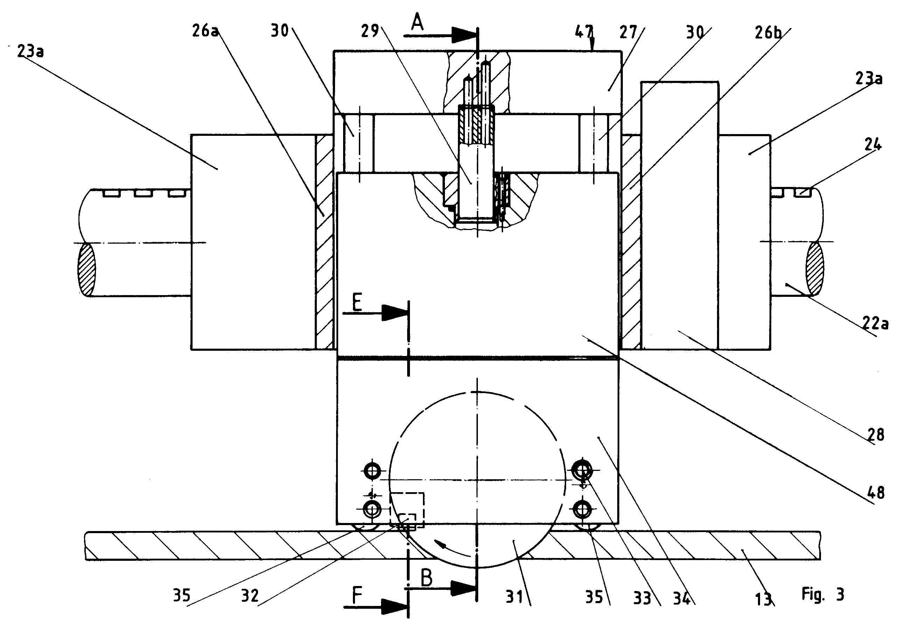

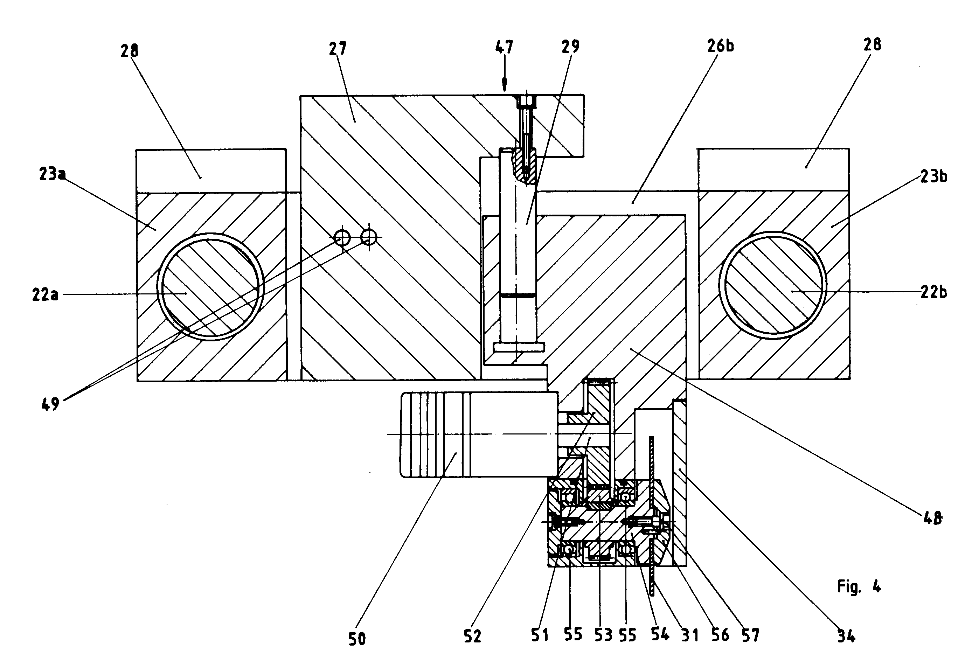

In Fig. 2 ist die als NC-Säge ausgebildete Querschneidestation 14 in grösserer Darstellung gezeigt. Sie besteht aus einem Gestell 19, in dem sich zwei parallel ausgerichtete Führungsachsen 20a,b in x-Richtung befinden. Auf diesen Führungsachsen 20a,b ist jeweils ein Laufwagen 21a,b verschieblich gelagert. Diese beiden Laufwagen 21a,b sind durch zwei parallel ausgerichtete Führungsachsen 22a,b in y-Richtung miteinander verbunden. Diese Führungsachsen 22a,b sind so ausgerichtet, dass sie senkrecht zur Vorlaufrichtung der Elektrolaminatbahn 13 stehen. Auf den Führungsachse 22a,b läuft ein Schlitten 23, der aus zwei, jeweils auf der entsprechenden Führungsachse 22a,b beweglich gelagerten Teilen 23a,b besteht. Zwischen diesen beiden Teilen 23a,b und an diesen befestigt, befindet sich der eigentliche Sägekopf 47. Sowohl der Schlitten 23 wie auch mindestens einer der Wagen 21a,b ist motorisch unter Steuerung durch den Rechner im Schaltschrank 17 angetrieben. Der Antrieb kann dabei, wie in Fig. 2 anhand der Führungsbahnen 22a,b gezeigt ist, durch eine auf diesen Führungsbahnen aufgebrachte Verzahnung 24, in die ein in der Zeichnung nicht dargestelltes, im Schlitten 23 bzw. in den Laufwagen 21a,b befestigtes und von einem Motor angetriebenes Ritzel eingreift, erfolgen. Bei diesen Antriebsmotoren kann es sich um Elektro- oder Hydraulikmotoren handeln. Das Ritzel und der Antriebsmotor für den Schlitten 23 sind in einem in den beiden Teilen 23a,b des Schlittens 23 integrierten Antriebsblock 28 untergebracht (siehe Fig. 3 und 4). Die Spannungsversorgung bzw. die Zuleitungen für die Hydraulikflüssigkeit für diese Antriebsmotoren verläuft in den flexiblen Kabelschächten 25. Durch entsprechende Ansteuerung der Wagen 21a,b und des Schlittens 23 unter Berücksichtigung der Vorlaufbewegung der Elektrolaminatbahn 13 kann jede beliebige zweidimensionale Bahnkurve vom Sägekopf 47 ausgeführt werden.

Die beiden Teile 23a,b des Schlittens 23 tragen, wie in Fig. 3 und Fig. 4 zu sehen ist, den Sägekopf 47. Dieser Sägekopf 47 besteht aus einem Halteblock 27, der mittels zweier seitlich angebrachter Haltebügel 26a,b an dem Schlitten 23 befestigt ist. Diese Befestigung ist in Fig. 4 durch Schraublöcher 49 angedeutet. In dem Halteblock 27 ist an zwei Führungsstangen 30 der Sägeblatt-Träger 48 mittels eines Hydraulikzylinders 29 in vertikaler Richtung verschieblich gelagert. Damit kann das Sägeblatt 31, das sich im unteren Teil des Sägeblatt-Trägers 48 befindet, auf die Elektrolaminatbahn 13 zum Sägen aufgesetzt bzw. nach dem Sägen beim Zurückfahren in die Ausgangsposition auch von der Elektrolaminatbahn 13 abgehoben werden. Anstelle des Hydraulikzylinders 29 kann für die vertikale Bewegung auch ein Linear-Elektromotor vorgesehen sein. Im unteren Teil des Sägeblatt-Trägers 48 befindet sich ausserdem eine mit Schrauben 33 befestigte Abdeckplatte 34, nach deren Abnahme das Sägeblatt 31 leicht ausgewechselt werden kann. Wie in Fig. 3 ersichtlich, liegt beim Sägen der Elektrolaminatbahn 13 derjenige Teil der Elektrolaminatbahn 13, der entsprechend der Drehrichtung im Eingriffsbereich der Zähne des Sägeblatts 31 liegt, auf einer durch die Abdeckplatte 34 verdeckt liegenden Seitenabstützung 32 auf. Der übrige Teil der Elektrolaminatbahn 13 im Bereich des Sägeblatt-Trägers 48 läuft auf Rollen 35, die sowohl der Abstützung als auch als Abstandshalter zwischen dem Sägeblatt-Träger 48 und der Elektrolaminatbahn 13 dienen.

Der Antrieb des Sägeblatts 31 ist im Detail in Fig. 4 zu sehen. Im unteren Teil des Sägeblatt-Trägers 48 ist ein Hydraulikmotor 50 angebracht, dessen Zuleitungen aus Gründen der Übersichtlichkeit nicht eingezeichnet sind. Auf einer Welle 51 des Hydraulikmotors 50 sitzt ein Zahnrad 52, das mit einer Verzahnung 53 auf der Sägeblattwelle 54 kämmt. Diese Sägeblattwelle 54 ist auf Kugellagern 55 im Sägeblatt-Träger 48 gelagert. Das Sägeblatt 31 ist auf der Sägeblattwelle 54 mit einer Scheibe 56 und einer Schraube 57 zentrisch festgespannt. Anstelle des Hydraulikmotors 50 kann auch ein Elektromotor vorgesehen sein.

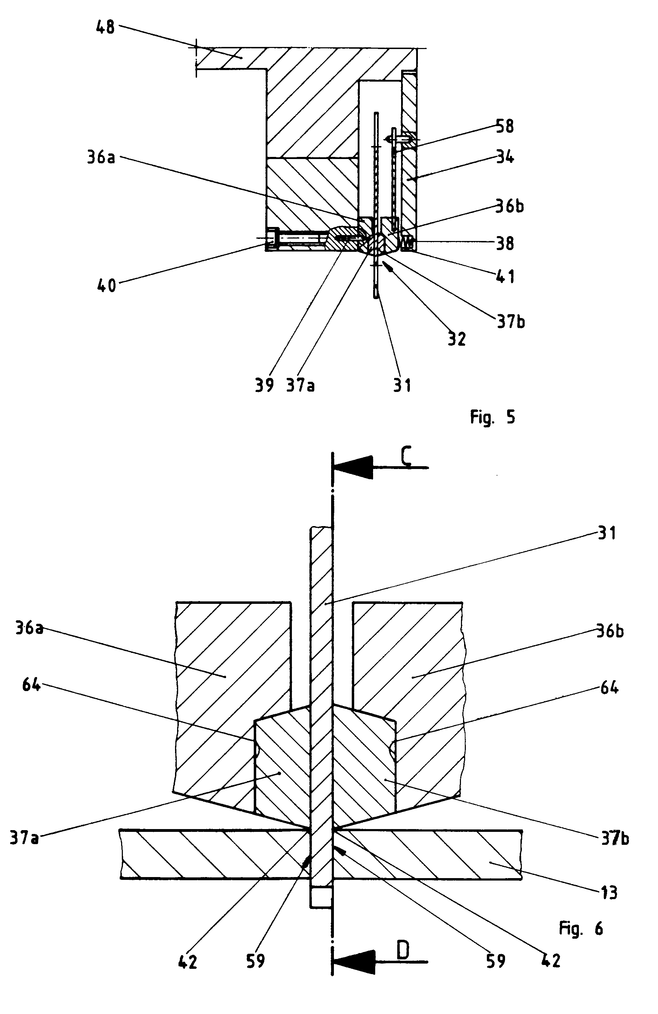

Die Seitenabstützung 32 ist ausführlicher in Fig. 5 entsprechend dem Schnitt E-F aus Fig. 3 gezeigt. Sie besteht aus zwei Stützplatten 36a,b, die links und rechts vom Sägeblatt 31 angebracht sind und Nuten 64 zur Aufnahme von jeweils einem Schneidenplättchen 37a,b besitzen. Die in der Zeichnung rechts liegende Stützplatte 36b wird mittels einer Feder 38, die sich mit ihrem gegenüberliegenden Ende in einer Nut 41 in der Abdeckplatte 34 abstützt, gegen das Schneidenplättchen 37b gepresst, so dass sich das Schneidenplättchen 37b an die rechte Fläche des Sägeblattes 31 anlegt. Die links liegende Stützplatte 36a kann mittels eines Zylinderstiftes 39 und einer Justierschraube 40 so verschoben werden, dass das Schneidenplättchen 37a an der linken Fläche des Sägeblatts 31 anliegt. Diese Anordnung wird mit Hilfe der Justierschraube 40 so eingerichtet, dass das Sägenblatt 31 vertikal steht, exakt rund läuft und gleichzeitig die Schneidenplättchen 37a,b unter leichtem Druck spielfrei an dem Sägeblatt 31 anliegen. Die in der Fig. 5 rechts angebrachte Stützplatte 36b ist zusätzlich mit einer Halteleiste 58 an der Abdeckplatte 34 gesichert.

Die Schneidenplättchen 37a,b bestehen aus Hartmetall und besitzen einen trapezförmigen Querschnitt, wie aus der Fig. 6 zu ersehen ist.

Da sie nur leicht gegen das Sägeblatt 31 angepresst werden, entstehen auf dem Sägeblatt auf den Seitenflächen praktisch keine Abnützungen, allenfalls leichte Polierspuren. Falls erforderlich kann dass Sägeblatt 31 jedoch auf der Oberfläche mit einer verschleissfreien Beschichtung versehen werden, beispielsweise mit einer solchen aus Titankarbid. Die Schneidenplättchen 37a,b besitzen an den dem Drehmittelpunkt des Sägeblattes 31 abgewandten Eckpunkten des Trapezes, die an der längeren Grundseite angebracht sind, spitz zulaufende Schneiden 42. Auf diesen Schneiden, die als längliche Kanten in y-Richtung ausgebildet sind und eine Breite von einigen wenigen 1/10 mm in x-Richtung besitzen, liegt die Elektrolaminatbahn 13 links und rechts von der Schnittkante 59 fest auf.

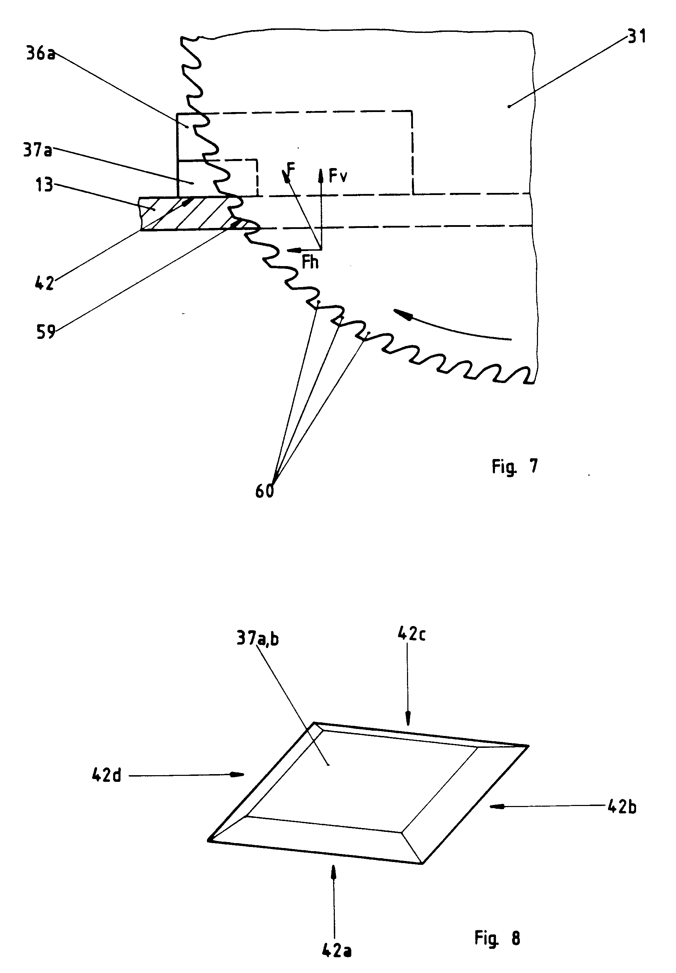

Die Seitenabstützung 32 wird an der Stelle entsprechend der Drehrichtung des Sägeblattes 31 angebracht, an der die Zähne 60 des Sägeblattes 31 in den noch ungeschnittenen Teil der Elektrolaminatbahn 13 eintauchen. Wie in Fig. 7 zu sehen, übt das Sägeblatt 31 damit eine Kraft F in tangentialer Richtung am Umfang des Sägeblattes auf die Elektrolaminatbahn 13 aus. Diese Kraft F lässt sich in eine vertikale Komponente Fv und in eine horizontale Komponente Fh zerlegen. Die vertikale Kraftkomponente Fv drückt die Elektrolaminatbahn 13 gegen die kantenförmigen Schneiden 42 der Schneidenplättchen 37a,b, so dass die Elektrolaminatbahn 13 im Randbereich entlang der Schnittkante 59 während des Sägevorgangs fest abgestützt ist. Dadurch erhält man saubere, gratfreie Schnittkanten, von denen sich weder Kupferspäne noch Glasfasern aus dem Laminatkern abheben.

In Vorschubrichtung des Schlittens 23 gesehen gleiten daher die Schneiden 42 über die Elektrolaminatbahn 13 im Bereich der Schnittkanten 59 hinweg, wodurch am Rand der Schnittkante 59 eine leichte Schleifspur auf der metallkaschierten Seite entsteht. Da die Schneiden 42 in y-Richtung spitz ausgebildet sind, ist diese Schleifspur jedoch nur wenige 1/10-mm breit, so dass sie nicht stört. Durch dieses Schleifen der Schneiden 42 auf dem Elektrolaminat werden die Spitzen der Schneiden 42 nur sehr langsam abgenützt und abgeschliffen, das die Schneidenplättchen 37ab aus Hartmetall bestehen. Ist die Spitze sowiet abgerundet, dass deren Abstützfunktion beeinträchtigt wird, so ist durch Öffnen der Schrauben 33 und Abnahme der Abdeckplatte 34 entsprechend der Fig. 3 ein leichtes Auswechseln der Schneidenplättchen 37a,b möglich.

Durch eine besondere Ausgestaltung gelingt es, die Standzeiten der Schneidenplättchen 37a,b weiter zu erhöhen. Die Schneidenplättchen werden dazu mit quadratischer Grundfläche, das ist die am Sägeblatt 31 anliegende Fläche, gefertigt und an allen vier Kanten mit Schneiden 42a bis d versehen, so dass sie das Aussehen eines flachen Pyramidenstumpfs besitzen, wie in Fig. 8 zu sehen ist. Ist nun die erste Schneide 42a an einer Kante abgenützt, so genügt es das Schneidenplättchen 37a,b um 90 Grad zu drehen, so dass die Schneide 42b an der nächsten Kante als Abstützung dient. Ist diese Schneide 42b abgenützt, so setzt man die Schneide 42c, usw. ein. Damit kann das Schneidenplättchen 37a,b insgesamt viermal gedreht werden, ehe alle Schneiden 42a-d abgenützt sind und das Schneidenplättchen 37a,b nachgeschliffen werden muss.

Der Metallstreifen, der in der Schnittkante 59 von der Kaschierung durch die Kupferfolie beim Sägen entsteht, sowie die Späne vom Glasfaserlaminatkern werden mittels Unterdruck abgesaugt. Dazu dient der in Fig. 2 sichtbare Absaugschlauch 43.

Um gratfreie Schnittkanten zu erhalten ist eine feste Abstützung der Schnittkante während des Sägevorgangs nötig. Wie bereits erläutert, wird dazu die vertikale Kraftkomponente Fv der Sägeblattdrehung benützt, die die Schnittkante an die Schneide des Schneidenplättchen andrückt. Sollte diese Kraftkomponente nicht ausreichen, so kann die Schnittkante noch zusätzlich mit mechanischen Mitteln, wie Rollen u. dgl., oder mit Vakuum an die Schneide angepresst werden.

Mit der erfindungsgemässen Vorrichtung lassen sich durch entsprechende Ansteuerung der NC-Säge beliebige Platten aus der Elektrolaminatbahn 13 aussägen. In vielen Fällen werden jedoch rechtwinklige Platten mit derselben Breite wie die Elektrolaminatbahn 13 mit variablen Längen gewünscht. Dazu wird der Sägekopf 47 in x-Richtung mit derselben Geschwindigkeit wie die Vorlaufgeschwindigkeit der Elektrolaminatbahn 13 bewegt. Dies wird erreicht, indem die Laufwagen 21a,b der Führungsachsen 20a,b (siehe Fig. 2) in x-Richtung während des Sägevorgangs nicht angetrieben, sondern starr mit der Elektrolaminatbahn 13 gekoppelt werden, so dass die Laufwagen 21a,b direkt von der Elektrolaminatbahn 13 bewegt werden. Zur Erreichung dieser starren Kopplung werden die Laufwagen 21a,b mit einem Querträger 61 miteinander verbunden. An diesem Querträger 61 befinden sich mehrere Längsträger 62, die wiederum eine Saugplatte 63 tragen. Die Saugplatte 63 liegt mittels Vakuum auf der zu sägenden Platte in der Elektrolaminatbahn 13 während des Sägevorgangs auf. Die Zuleitungen für das Vakuum sind in den Längsträgern 62 integriert. Nachdem der Sägevorgang beendet ist, wird die Platte 15 genau über die Palette der Stapeleinrichtung 16 gefahren, das Vakuum abgeschaltet und die Platte 15 abgelegt. Anschliessend fährt der Sägekopf 47 in die Ausgangsposition für den nächsten Sägevorgang zurück.

Der Rand der Elektrolaminatbahn 13 besteht in einer gewissen Breite aus teilweise drucklos ausgehärtetem Harz, wenn diese die Doppelbandpresse 1 verlässt. Daher muss dieser Rand besäumt werden. Dazu dienen Kreissägen, deren Sägeblätter parallel zur Vorlaufrichtung der Elektrolaminatbahn 13, also in x-Richtung, stehen. Diese Randsägen 44 sind links und rechts am Rande der Elektrolaminatbahn 13 im Gestell 19 in Vorlaufrichtung der Elektrolaminatbahn 13 vor dem Sägekopf 47 angebracht, wie man anhand von Fig. 2 sieht. Diese Randsägen 44 sind in x- und y-Richtung feststehend, also nicht verfahrbar im Gestell 19 befestigt. Ansonsten sind sie jedoch gleich wie der Sägekopf 47 ausgebildet und damit in vertikaler Richtung mittels eines Zylinders bewegbar, so dass sie in Eingriffsposition oder ausserhalb Eingriffsposition mit der Elektrolaminatbahn 13 gebracht werden können. Die Randsägen 44 besitzen auch die bereits erläuterte, erfindungsgemässe Seitenabstützung der Schnittkante am Sägeblatt. Damit erfolgt auch der Randbeschnitt der Elektrolaminatbahn 13 mit minimalem Abfall und sämtliche Kanten der ausgesägten Platten 15 sind gratfrei. Für jede Randsäge 44 ist im Gestell 19 eine Ersatzsäge 45 angebracht, so dass bei Sägeblatt- oder Schneidenplättchenwechsel die Ersatzsäge 45 in Position gebracht wird und die Produktion der Elektrolaminatbahn 13 nicht unterbrochen werden braucht. Der Antrieb der Sägeblätter der Randsägen 44 und Ersatzsägen 45 erfolgt wiederum über Hydraulik- oder Elektromotoren. Im vorderen Teil des Gestells 19 wird die Elektrolaminatbahn 13 durch Rollen 46 abgestützt, so dass ein Durchhängen derselben verhindert wird. Solche Rollen können selbstverständlich an jeder benötigten Stelle im Gestell 19 angebracht werden.

Das erfindungsgemässe Verfahren und die zugehörige Vorrichtung sind beispielhaft an einer Elektrolaminatbahn, die aus kupferkaschiertem Glasfasergewebe besteht, erläutert. Selbstverständlich können auch sonstige metallkaschierten Laminate entsprechend diesem Verfahren und mit der beschriebenen Vorrichtung in Platten aufgeteilt werden.

## Patentansprüche

1. Verfahren zur Aufteilung einer kontinuierlich vorlaufenden endlosen metallkaschierten Laminatbahn, bestehend aus einem Schichtstoffkern, der sich wiederum aus einzelnen mit Duroplastharz imprägnierten Bahnen zusammensetzt, und auf einer oder beiden Oberflächen aufgelegten Bahn aus Metallfolie, wobei die einzelnen Bahnen mittels Flächendruck und Wärme in einer Doppelbandpresse zu einem kompakten Laminat verpresst sind, in einzelne Platten, wobei die Aufteilung kommisionsweise mittels einer Säge in beliebige innerhalb der Bahnbreite passende Grössen durch Rechnereinsatz erfolgt, **dadurch gekennzeichnet**, daß die Schnittkante auf der metallkaschierten Laminatbahn am Sägeblatt der Säge seitlich abgestützt ist.

2. Verfahren nach Anspruch 1, **dadurch gekennzeichnet**, dass die Aufteilung der metallkaschierten Laminatbahn in einzelne Platten erst erfolgt, wenn die Masse der einzelnen Platten einer ganzen Charge in den Rechner eingegeben sind.

3. Verfahren nach Ansprüche 1 und 2, **dadurch gekennzeichnet**, dass die Aufteilung der metallkaschierten Laminatbahn in einzelne Platten in einer vom Rechner bestimmten Reihenfolge durchgeführt wird, die so vom Rechner optimiert ist, dass ein minimaler Verschnitt resultiert.

4. Verfahren nach Anspruch 2 oder 3, **dadurch gekennzeichnet**, dass die Platten von verschiedenen Chargen auf verschiedenen Paletten gestapelt werden.

5. Verfahren nach einem der Ansprüche 1 bis 4, **dadurch gekennzeichnet**, dass der drucklos ausgehärtete Rand der metallkaschierten Laminatbahn vor der Aufteilung in einzelne Platten abgesägt wird.

6. Verfahren nach einem der Ansprüche 1, 2 oder 5, **dadurch gekennzeichnet**, dass eine Aufteilung der metallkaschierten Laminatbahn in rechtwinklige Platten mit der Breite der Laminatbahn erfolgt, indem die Säge in Vorlaufrichtung der Laminatbahn mit derselben Geschwindigkeit wie die Laminatbahn bewegt wird.

7. Verfahren nach Anspruch 6, **dadurch gekennzeichnet**, dass die in Vorlaufrichtung liegende Achse der Säge während des Schneidvorgangs fest mit der Laminatbahn gekoppelt ist.

8. Verfahren nach einem der Ansprüche 1 bis 7 , **dadurch gekennzeichnet**, dass es sich bei der metallkaschierten Laminatbahn um eine Elektrolaminatbahn handelt, deren Schichtstoffkern mit elektrolytisch abgeschiedenen Kupferfolien verpresst ist.

9. Vorrichtung zur Durchführung des Verfahrens nach einem der Ansprüche 1 bis 8, bestehend aus Abwickeleinheiten für die Schichtstoff- und Metallfolienbahnen, einer Doppelbandpresse und einer hinter der Doppelbandpresse angeordneten Querschneideeinheit, welche aus einer durch einen Rechner bahngesteuerten NC-Säge (14) besteht, deren Sägekopf (47) mittels auf Führungsachsen (20a,b) laufender Laufwagen (21a,b) in Vorlaufrichtung der metallkaschierten Laminatbahn (13) und einem Schlitten (23) auf Führungsachsen (22a,b) in der dazu quer verlaufenden Richtung in der Ebene der metallkaschierten Laminatbahn (13) bewegbar ist, dadurch gekennzeichnet, dass das im Sägekopf (47) befindliche Sägeblatt (31) eine Seitenabstützung enthält, die mit einer Kante längs neben der Schnittkante (59) die metallkaschierte Laminatbahn (13) während des Sägevorgangs abstützt, wobei
die Seitenabstützung für das Sägeblatt (31) aus zwei einander gegenüberliegend auf verschiedenen Seiten des Sägeblatts (31) angeordneten Elementen (37a,b) besteht, die mit einer Seitenfläche unter leichtem Druck am Sägeblatt (31) angelegt sind.

10. Vorrichtung nach Anspruch 9, **dadurch gekennzeichnet**, dass der Sägekopf (47) in vertikaler Richtung, also senkrecht zur Oberfläche der metallkaschierten Laminatbahn (13), bewegbar ist, so dass das Sägeblatt (31) in oder ausser Eingriff mit der metallkaschierten Laminatbahn (13) bringbar ist.

11. Vorrichtung nach Anspruch 10, **dadurch gekennzeichnet**, dass der Sägekopf (47) in vertikaler Richtung mittels eines hydraulischen Zylinders (29) bewegbar ist.

12. Vorrichtung nach Anspruch 10, **dadurch gekennzeichnet**, dass der Sägekopf (47) in vertikaler Richtung mittels eines Linear-Elektromotors bewegbar ist.

13. Vorrichtung nach einem der Ansprüche 9 bis 12, **dadurch gekennzeichnet**, dass die Elemente (37a, b) Schneidenplättchen aus Hartmetall sind, und die metallkaschierte Laminatbahn (13) aufgrund einer aus der Drehrichtung des Sägeblatts (31) herrührenden Kraftkomponente gegen eine weitere schmale Kantenfläche der Schneidenplättchen (37a,b), die als Schneide (42) in Richtung der Schnittkante (59) ausgebildet ist und direkt neben dieser verläuft, gedrückt wird, so dass die Schneide (42) bei Bewegung des Sägekopfes (47) auf der metallkaschierten Laminatbahn (13) gleitet.

14. Vorrichtung nach Anspruch 13, **dadurch gekennzeichnet**, dass die Schneide (42) nur wenige 1/10 mm breit ist.

15. Vorrichtung nach Anspruch 13 oder 14, **dadurch gekennzeichnet**, dass die Schneidenplättchen (37a,b) in den Nuten (64) zweier Stützplatten (36a,b) sitzen und mittels eines mechanischen Kraftübertragungsmittels gegen das Sägeblatt (31) angelegt werden.

16. Vorrichtung nach Anspruch 15, **dadurch gekennzeichnet**, dass dieses mechanische Kraftübertragungsmittel aus einer Feder (38) besteht, die zwischen der dem Sägeblatt abgewandten Fläche der Stützplatte (36b) und dem Nutgrund einer Nut (41), die sich in einer Abdeckplatte (34) im Sägekopf (47) befindet, angebracht ist.

17. Vorrichtung nach Anspruch 15, **dadurch gekennzeichnet**, dass dieses mechanische Kraftübertragungsmittel aus einem auf die dem Sägeblatt (31) abgewandten Fläche des Schneidenplättchens (37a) wirkendem Zylinderstift (39) und einer auf diesen wirkenden, in dem Sägekopf (47) sitzenden Justierschräbe (40) besteht.

18. Vorrichtung nach einem der Ansprüche 13 bis 17, **dadurch gekennzeichnet**, dass die Oberfläche des Sägeblatts (31) mit einer verschleissfesten Beschichtung versehen ist.

19. Vorrichtung nach Anspruch 18, **dadurch gekennzeichnet**, dass die Oberflächenbeschichtung aus Titankarbid besteht.

20. Vorrichtung nach einem der Anspruche 13 bis 19, **dadurch gekennzeichnet**, dass das Schneidenplättchen (37a,b) einen trapezförmigen Querschnitt besitzt, wobei die längere Grundseite des Trapezes am Sägeblatt (31) anliegt und die Schneide (42) von der an der Grundseite befindlichen, dem Drehmittelpunkt des Sägeblattes (31) abgewandten Ecke des Trapezes gebildet wird.

21. Vorrichtung nach Anspruch 20, **dadurch gekennzeichnet**, dass das Schneidenplättchen (37a,b) die Form eines flachen Pyramidenstumpfs mit quadratischer Grundfläche besitzt, wobei alle vier Kanten der Grundfläche mit Schneiden (42a-d) versehen sind.

22. Vorrichtung nach einem der Ansprüche 13 bis 21, **dadurch gekennzeichnet**, dass die Anpressung der metallkaschierten Laminatbahn (42) gegen die Schneide (42) der Schneidenplättchen (37a,b) mittels Vakuum verstärkt wird.

23. Vorrichtung nach einem der Ansprüche 13 bis 21, **dadurch gekennzeichnet**, dass die Anpressung der metallkaschierten Laminatbahn (13) gegen die Schneiden (42) der Schneidenplättchen (37a,b) mit Rollen verstärkt wird.

24. Vorrichtung nach einem der Ansprüche 9 bis 23, **dadurch gekennzeichnet**, dass der beim Sägen in der Schnittkante (59) entstehende Metallstreifen und die Späne durch einen an Unterdruck angeschlossenen Absaugschlauch (43) abgesaugt werden.

25. Vorrichtung nach einem der Ansprüche 9 bis 24, **dadurch gekennzeichnet**, dass eine Saugplatte (63) an dem in Vorlaufrichtung der metallkaschierten Laminatbahn (13) beweglichen Laufwagen (21a,b) angebracht ist, die währen des Sägevorgangs auf der metallkaschierten Laminatbahn (13) fest mittels Unterdruck aufliegt und nur der Schlitten (23) senkrecht zur Vorlaufrichtung der metallkaschierten Laminatbahn (13) angetrieben wird, so dass rechtwinklige Platten mit der Breite der metallkaschierten Laminatbahn (13) entstehen.

26. Vorrichtung nach einem der Ansprüche 9 bis 25, **dadurch** **gekennzeichnet**, dass zwei in Vorlaufrichtung der metallkaschierten Laminatbahn (13) vor dem Sägekopf (47) befindliche, links und rechts am Rande der metallkaschierten Laminatbahn (13) angebrachte sowohl in Vorlaufrichtung der metallkaschierten Laminatbahn (13) wie auch dazu senkrecht in der Ebene der metallkaschierten Laminatbahn (13) feststehende Kreissägen (44) mit einer Seitenabstützung des Sägeblattes für den Randbeschnitt der metallkaschierten Laminatbahn (13) vorhanden sind.

27. Vorrichtung nach Anspruch 26, **dadurch gekennzeichnet**, dass bei jeder Kreissäge (44) eine Ersatzsäge (45) mit einer Seitenabstützung des Sägeblattes angeordnet ist.

28. Vorrichtung nach Anspruch 26 oder 27, **dadurch gekennzeichnet**, dass die Kreissägen (44) und Ersatzsägen (45) in vertikaler Richtung bezüglich der metallkaschierten Laminatbahn (13) bewegbar sind, so dass sie in oder ausser Eingriff mit der metallkaschierten Laminatbahn (13) gebracht werden können.

29. Vorrichtung nach Anspruch 28, **dadurch gekennzeichnet**, dass die Kreissägen (44) für den Randbeschnitt mittels eines hydraulischen Zylinders vertikal bewegbar sind.

30. Vorrichtung nach Anspruch 28, **dadurch gekennzeichnet**, dass die Kreissägen (44) für den Randbeschnitt mittels eines Elektromotors vertikal bewegbar sind.

31. Vorrichtung nach einem der Ansprüche 9 bis 30, **dadurch gekennzeichnet**, dass die Sägeblätter (31) des Sägekopfes (47) und der Kreissägen (44,45) für den Randbeschnitt mit Hydraullikmotoren angetrieben werden.

32. Vorrichtung nach einem der Ansprüche 9 bis 30, **dadurch gekennzeichnet**, dass die Sägeblätter (31) des Sägekopfes (47) und der Kreissägen (44,45) für den Randbeschnitt mit Elektromotoren angetrieben werden.

33. Vorrichtung nach einem der Ansprüche 9 bis 32, **dadurch gekennzeichnet**, dass der Antrieb der Laufwagen (21a,b) und des Schlittens (23) für die Bahnbewegung des Sägekopfes (47) mittels Hydraulikmotoren erfolgt.

34. Vorrichtung nach einem der Ansprüche 9 bis 32, **dadurch gekennzeichnet**, dass der Antrieb der Laufwagen (21a,b) und des Schlittens (23) für die Bahnbewegung des Sägekopfes (47) mittels Elektromotoren erfolgt.

35. Vorrichtung nach mindestens einem der Ansprüche 9 bis 34, **dadurch gekennzeichnet**, dass die einzelnen aus der metallkaschierten Laminatbahn (13) gesägten Platten (15) in einer Stapeleinrichtung (16) auf Paletten gestapelt werden.

## Claims

1. Method for dividing a continuously advancing endless metal-coated laminate web, which consists of a layered material core, which is in turn composed of individual webs impregnated with thermosetting resin, and a web of metal foil laid onto one or both surfaces, wherein the individual webs are pressed together into a compact laminate by means of areal pressure and heat in a double-belt press, into individual plates, wherein the dividing-up takes place to order through computer deployment by means of a saw into any desired sizes fitting within the width of the web, characterised thereby, that the cut edge on the metal-coated laminate web is supported laterally at the saw blade of the saw.

2. Method according to claim 1, characterised thereby, that the dividing-up of the metal-coated laminate web into individual plates takes place only after the mass of the individual plates of an entire charge has been entered into the computer.

3. Method according to claim 1 and 2, characterised thereby, that the dividing-up of the metal-coated laminate web into individual plates is performed in a sequence determined by the computer and so optimised by the computer that a minimum of cutting waste results.

4. Method according to claim 2 or 3, characterised thereby, that the plates from different charges are stacked on different pallets.

5. Method according to one of the claims 1 to 4, characterised thereby, that the rim, which is cured free of pressure, of the metal-coated laminate web is sawn off before the dividing-up into individual plates.

6. Method according to one of the claims 1, 2 and 5, characterised thereby, that a dividing-up of the metal-coated laminate web into rectangular plates of the width of the laminate web takes place in that the saw is moved in the direction of advance of the laminate web at the same speed as the laminate web.

7. Method according to claim 6, characterised thereby, that that axle of the saw, which lies in the direction of advance, is firmly coupled with the laminate web during the cutting operation.

8. Method according to one of the claims 1 to 7, characterised thereby, that an electrical laminate web, the layered material core of which is compressed together with electrolytically precipitated copper foils, is concerned in the case of the metal-coated laminate web.

9. Device for the performance of the method according to one of the claims 1 to 8, and consisting of winding-off units for the webs of layered substance and metal foil, a double-belt press and a crosscutting unit, which is arranged downstream of the double-belt press and consists of a numerically controlled saw (14), the path of which is controlled by a computer and the saw head (47) of which is movable in the direction of advance of the metal-coated laminate web (13) by means of carriages (21a, b) running on guide axles (20a, b) and in the direction extending transversely thereto in the plane of the metal-coated laminate web (13) by means of slides (23) on guide axles (22a, b), characterised thereby, that the saw blade (31) disposed in the saw head (47) contains a lateral support which by one edge supports the metal-coated laminate web (13) longitudinally beside the cut edge (59) during the sawing operation, wherein the lateral support for the saw blade (31) consists of two elements (37a, b), which are arranged one lying opposite the other on different sides of the saw blade (31) and are laid against the saw blade (31) under slight pressure by one side surface.

10. Device according to claim 9, characterised thereby, that the saw head (47) is movable in vertical direction, thus perpendicularly to the surface of the metal-coated laminate web (13), so that the saw blade (31) can be brought into and out of engagement with the metal-coated laminate web (13).

11. Device according to claim 10, characterised thereby, that the saw head (47) is movable in vertical direction by means of an hydraulic cylinder (29).

12. Device according to claim 10, characterised thereby, that the saw head (47) is movable in vertical direction by means of a linear electrical motor.

13. Device according one of the claims 9 to 12, characterised thereby, that the elements are cutting edge platelets (37a, b) of hard metal and the metal-coated laminate web (13) is urged by reason of a force component, which is due to the direction of rotation of the saw blade (31), against a further narrow edge surface of the cutting edge platelets (37a, b), which is formed as cutting edge (42) in the direction of the cut edge (59) and extends directly beside this so that the cutting edge (42) slides on the metal-coated laminate web (13) during the movement of the saw head (47).

14. Device according to claim 13, characterised thereby, that the cutting edge (42) is only a few tenths of a millimetre wide.

15. Device according to claim 13 or 14, characterised thereby, that the cutting edge platelets (37a, b) sit in the grooves (64) of two support plates (36a, b) and are laid against the saw blade (31) by means of a mechanical force transmission means.

16. Device according to claim 15, characterised thereby, that this mechanical force transmission means consists of a spring (38), which is mounted between that surface of the support plate (36b), which is remote from the saw blade (31), and the base of a groove (41), which is situated in a cover plate (34) in the saw head (47).

17. Device according to claim 15, characterised thereby, that this mechanical force transmission means consists of a cylindrical pin (39), which acts on that surface of the cutting edge platelet (37a), which is remote from the saw blade (31), and an adjusting screw (40) acting on this pin and sitting in the saw head (47).

18. Device according to one of the claims 13 to 17, characterised thereby, that the surface of the saw blade (31) is provided with a wear-resistant coating.

19. Device according to claim 18, characterised thereby, that the surface coating consists of titanium carbide.

20. Device according to one of the claims 13 to 19, characterised thereby, that the cutting edge platelet (37a, b) has a trapezium-shaped cross-section, wherein the longer base side of the trapezium lies against the saw blade (31) and the cutting edge (42) is formed by that corner of the trapezium, which is situated at the base side and remote from the centre of rotation of the saw blade (31).

21. Device according to claim 20, characterised thereby, that the cutting edge platelet (37a, b) has the shape of a flat pyramidal frustum with square base surface, wherein all four edges of the base surface are provided with cutting edges (42a, b, c, d).

22. Device according to one of the claims 13 to 21, characterised thereby, that the pressing of the metal-coated laminate web (13) against the cutting edges (42) of the cutting edge platelets (37a, b) is re-inforced by means of vacuum.

23. Device according to one of the claims 13 to 21, characterised thereby, that the pressing of the metal-coated laminate web (13) against the cutting edges (42) of the cutting edge platelets (37a, b) is re-inforced by rollers.

24. Device according to one of the claims 9 to 23, characterised thereby, that the metal strip, which arises in the cut edge (59) during sawing, and the shavings are sucked away through a suction hose (43) connected to underpressure.

25. Device according to one of the claims 9 to 24, characterised thereby, that a suction plate (63) is mounted at the carriage (21a, b), which is movable in the direction of advance of the metal-coated laminate web (13) and rests firmly on the metal-coated laminate web (13) by means of underpressure during the sawing operation and only the slide (23) is driven perpendicularly to the direction of advance of the metal-coated laminate web (13) so that rectangular plates of the width of the metal-coated laminate web (13) arise.

26. Device according to one of the claims 9 to 25, characterised thereby, that two circular saws (44), which are disposed in front of the saw head (47) in the direction of advance of the metal-coated laminate web (13), are mounted to the left and the right of the edge of the metal-coated laminate web (13) and which are stationary in the direction of advance of the metal-coated laminate web (13) as well as also perpendicularly thereto in the plane of the metal-coated laminate web (13), with a lateral support for the saw blade are present for the trimming of the edge of the metal-coated laminate web (13).

27. Device according to claim 26, characterised thereby, that a substitute saw (45) with a lateral support for the saw blade is arranged alongside each circular saw (44).

28. Device according to claim 26 or 27, characterised thereby, that the circular saws (44) and the substitute saws (45) are movable in vertical direction relative to the metal-coated laminate web (13) so that they can be brought into and out of engagement with the metal-coated laminate web (13).

29. Device according to claim 28, characterised thereby, that the circular saws (44) for the trimming of the edge are vertically movable by means of an hydraulic cylinder.

30. Device according to claim 28, characterised thereby, that the circular saws (44) for the trimming of the edge are vertically movable by means of an electrical motor.

31. Device according to one of the claims 9 to 30, characterised thereby, that the saw blades (31) of the saw head (47) and of the circular saws (44, 45) for the trimming of the edge are driven by hydraulic motors.

32. Device according to one of the claims 9 to 30, characterised thereby, that the saw blades (31) of the saw head (47) and of the circular saws (44, 45) for the trimming of the edge are driven by electrical motors.

33. Device according to one of the claims 9 to 32, characterised thereby, that the drive of the carriages (21a, b) and of the slides (23) for the path movement of the saw head (47) takes place by means of hydraulic motors.

34. Device according to one of the claims 9 to 32, characterised thereby, that the drive of the carriages (21a, b) and of the slides (23) for the path movement of the saw head (47) takes place by means of electrical motors.

35. Device according to at least one of the claims 9 to 34, characterised thereby, that the individual plates (15) sawn out of the metal-coated laminate web (13) are stacked on pallets in a stacking equipment (16).

## Revendications

1. Procédé pour débiter en plaques une bande laminée continue à revêtement métallique, constituée d'un corps principal formé par l'assemblage de bandes imprégnées de résines thermodurcissables et recouvert sur une ou sur les deux faces d'une bande faite d'une feuille métallique, les différentes bandes étant réunies en un laminé compact par l'action de la pression et de la température dans une presse à double bande, la division en plaques étant effectuée, en fonction des commandes, par une scie découpant dans la largeur des dimensions déterminées par un calculateur, caractérisé en ce que le bord de la coupe est en appui latéral sur la bande laminée à revêtement métallique sur la lame de scie.

2. Procédé selon la revendication 1, caractérisé en ce que la division de la bande laminée métallisée en plaques individuelles ne s'effectue qu'après que les dimensions des plaques constituant une charge complète aient été prises en compte dans le calculateur.

3. Procédé selon la revendication 1 et 2, caractérisé en ce que la division de la bande laminée métallisée en plaques individuelles s'effectue selon une séquence définie par le calculateur de manière optimale, c'est-à-dire avec des chutes de découpe minimales.

4. Procédé selon la revendication 2 ou 3, caractérisé en ce que les plaques de chaque fournée sont empilées sur des palettes distinctes.

5. Procédé selon l'une des revendications 1 à 4, caractérisé en ce que le bord durci sans pression de la bande laminée métallisée est éliminé par sciage, avant la division en plaques.

6. Procédé selon l'une des revendications 1, 2 ou 5, caractérisé en ce que la division de la bande en plaques rectangulaires ayant la largeur de la bande s'effectue en même temps que la scie se déplace, dans le sens d'avancement de la bande et à la vitesse de celle-ci.

7. Procédé selon la revendication 6, caractérisé en ce que l'axe de la scie parallèle à la direction d'avancement de la bande, est solidement associé à la bande laminée, pendant l'opération de coupe.

8. Procédé selon l'une des revendications 1 à 7, caractérisé en ce que la bande laminée métallisée est du type électrolytique, dont l'âme de la matière à recouvrement est obtenu par pression de feuilles de cuivre obtenues par dépôt électrolytique.

9. Dispositif de mise en oeuvre du procédé selon l'une des revendications 1 à 8, comprenant des unités de déroulement fournissant les bandes des couches de matière et des revêtements métalliques, une presse à double bande suivie d'une unité de découpe transversale disposée derrière la presse à double bande équipée d'une scie (14) à commande numérique commandée par un calculateur, la tête de sciage (47) pouvant se déplacer par l'intermédiaire d'un chariot (21a, b) circulant sur des axes de guidage (20a, b) dans la direction d'avancement de la bande laminée métallisée (13) et par l'intermédiaire d'une glissière (23) coulissant sur des axes de guidage (22a, b) perpendiculairement à la direction précédente, dans le plan de la bande laminée, métallisée (13) caractérisé en ce que la lame de scie (31) montée dans la tête de sciage (47) est équipée d'un support latéral qui pendant le sciage, soutient la bande laminée métallisée (13) par appui d'un de ses bords le long de l'arête de coupe (59), le support latéral de la lame (31) étant constitué de deux éléments (37a, b) se faisant face de part et d'autre de la lame (31) sur laquelle ils s'appuient latéralement avec une faible pression.

10. Dispositif selon la revendication 9, caractérisé en ce que la tête de sciage (47) peut se déplacer verticalement, c'est-à-dire perpendiculairement au plan de la bande laminée métallisée (13), de manière à amener la lame de scie (31) en prise avec la bande, ou à l'en dégager.

11. Dispositif selon la revendication 10, caractérisé en ce que le mouvement vertical de la tête de sciage (47) est assuré par un vérin hydraulique (29).

12. Dispositif selon la revendication 10, caractérisé en ce que le mouvement vertical de la tête de sciage (47) est assuré par un moteur électrique linéaire.

13. Dispositif selon l'une des revendications 9 à 12, caractérisé en ce que les éléments d'appui sont constitués par des plaquettes de coupe (37a, b) en métal dur et que la bande laminée métallisée (13) sous l'action d'une composante dynamique liée au sens de rotation de la lame de scie (31) se trouve appliquée contre une zone marginale étroite des plaquettes (37a, b) qui a la forme d'un tranchant (42) dirigé vers l'arête de coupe (59) et se déplaçant directement le long de cette ligne, le mouvement de la tête de sciage (42) faisant glisser le tranchant (42) sur la bande laminée métallisée.

14. Dispositif selon la revendication 13, caractérisé en ce que le tranchant (42) a une largeur inférieure à 1/10 mm.

15. Dispositif selon la revendication 13 ou 14, caractérisé en ce que les plaquettes de coupe (37a, b) sont montées dans des rainures (64) de deux plaques d'appui (36a, b) et sont appliquées contre la lame de scie (31) par l'intermédiaire d'un moyen mécanique de transmission de force.

16. Dispositif selon la revendication 15, caractérisé en ce que le moyen mécanique de transmission de force est constitué par un ressort (38) en pression entre la face de la plaque d'appui (36b) située à l'opposé de la lame de scie et une rainure pratiquée dans une plaque de couverture (34) de la tête de sciage (47).

17. Dispositif selon la revendication 15, caractérisé en ce que le moyen mécanique de transmission de force est constitué par une tige cylindrique (39) agissant sur la face de la plaquette de coupe (37a) située à l'opposé de la lame de scie (31) et constituée par une vis de réglage (40) montée dans la tête de sciage (47) actionnant celle-ci.

18. Dispositif selon l'une des revendications 13 à 17, caractérisé en ce que la surface plane de la lame de scie (31) est munie d'un revêtement résistant à l'usure.

19. Dispositif selon la revendication 18, caractérisé en ce que le revêtement résistant à l'usure est du carbure de titane.

20. Dispositif selon l'une des revendications 13 à 19, caractérisé en ce que la plaquette de coupe (37a, b) a une section trapézoïdale, dont la plus longue base est au contact de la lame de scie (31) tandis que le tranchant (42) est constitué par l'angle du trapèze le plus éloigné du centre de rotation de la lame.

21. Dispositif selon la revendication 20, caractérisé en ce que la plaquette de coupe (37a, b) a la forme d'un tronc plat de pyramide ayant une base carrée dont les quatre arêtes portent les tranchants (42a, d).

22. Dispositif selon l'une des revendications 13 à 21, caractérisé en ce que l'application de la bande laminée métallisée (13) sur le tranchant (42) des plaquettes (37a, b) est renforcée par l'action du vide.

23. Dispositif selon l'une des revendications 13 à 21, caractérisé en ce que l'application de la bande laminée métallisée (13) sur les tranchants (42) des plaquettes de coupe (37a, b) est renforcée par des rouleaux.

24. Dispositif selon l'une des revendications 9 à 23, caractérisé en ce que les filets métalliques et les copeaux produits lors du sciage au niveau de l'arête de coupe (59) sont aspirés par un tuyau (43) raccordé à une dépression.

25. Dispositif selon l'une des revendications 9 à 24, caractérisé en ce que le chariot (21a, b) mobile dans la direction d'avancement de la bande laminée (13) est équipé d'une plaque d'aspiration (63) qui, pendant le sciage, est maintenue fermement appliquée par dépression sur la bande laminée (13), seule la glissière (23) étant déplacée perpendiculairement à l'avancement de la bande laminée (13), de sorte que les plaques découpées sont des rectangles ayant la largeur de la bande laminée (13).

26. Dispositif selon l'une des revendications 9 à 25, caractérisé en ce qu'il comporte en amont de la tête de sciage (47) par rapport au sens d'avancement de la bande laminée (13) à droite et à gauche de celle-ci, le long de ses bords, des scies circulaires (44), montées fixes par rapport à la direction d'avancement et la direction perpendiculaire, dans le plan de la bande laminée (13), les lames de ces scies étant équipées d'un appui latéral et servant à la découpe des bords de la bande laminée métallisée (13).

27. Dispositif selon la revendication 26, caractérisé en ce que près de chaque scie circulaire (44) est disposée une scie de remplacement (45) équipée d'un appui latéral de lame de scie.

28. Dispositif selon la revendication 26 ou 27, caractérisé en ce que les scies circulaires (44) et leurs scies de remplacement (45) sont mobiles verticalement par rapport au plan de la bande laminée métallisée (13) de manière à pouvoir être amenées en prise avec la bande ou en être dégagées.

29. Dispositif selon la revendication 28, caractérisé en ce que les scies circulaires (44) servant à découper les bords peuvent être déplacées verticalement au moyen d'un vérin hydraulique.

30. Dispositif selon la revendication 28, caractérisé en ce que les scies circulaires (44) servant à découper les bords peuvent être déplacées verticalement au moyen d'un moteur électrique.

31. Dispositif selon l'une des revendications 9 à 30, caractérisé en ce que les lames de la scie (31) de la tête de sciage (47) et des scies circulaires (44, 45) servant à découper les bords sont entraînées par des moteurs hydrauliques.

32. Dispositif selon l'une des revendications 9 à 30, caractérisé en ce que les lames de la scie (31) de la tête de sciage (47) et des scies circulaires (44, 45) servant à découper les bords sont entraînées par des moteurs électriques.

33. Dispositif selon l'une des revendications 9 à 32, caractérisé en ce que l'entraînement du chariot (21a, b) et de la glissière (23) permettant le déplacement de la tête de sciage (47) sont assurés par des moteurs hydrauliques.

34. Dispositif selon l'une des revendications 9 à 32, caractérisé en ce que l'entraînement du chariot (21a, b) et de la glissière (23) permettant le déplacement de la tête de sciage (47) est assuré par des moteurs électriques.

35. Dispositif selon au moins l'une des revendications 9 à 34, caractérisé en ce que les plaques (15) obtenues par sciage de la bande laminée métallisée (13) sont collectées dans un dispositif d'empilage (16), sur des palettes.
